# EUROPEAN PATENT APPLICATION

(11) **EP 1 983 072 A1**
(43) Date of publication of application: **22.10.2008**
(21) Application number: 07106669.0
(22) Date of filing: 20.04.2007
(51) Int. Cl.: C23C 14/56, H01L 51/56

(54) **Processing device and method for processing a subtrate**

(71) Applicant: Applied Materials, Inc., Santa Clara, CA 95054 (US)
(72) Inventor: Hoffmann, Uwe, 63755, Alzenau (DE); Dieguez-Campo, Jose Manuel, 63457, Hanau (DE)
(74) Representative: Lermer, Christoph

(57) **Abstract**

A processing device 1 for producing a layer system on a substrate, preferably a layer system including at least one layer of an organic light emitting semiconductor material (OLED), comprises: a configuration of one or more treatment stations A, 2 for processing said substrate in said treatment stations A, 2; and a first encapsulation module 5a comprising a first encapsulation tool 6a for providing an encapsulation element on said layer system deposited on said substrate. Furthermore, the processing device 1 comprises at least a second encapsulation module 5b comprising a second encapsulation tool 6b, wherein said processing device 1 is configured to provide said encapsulation element on said coated substrate in said first encapsulation module 5a or in said second encapsulation module 5b alternatively. By providing two encapsulation modules 5a and 5b one of the modules, e.g. the second module 5b, may be cleaned during a continuous operation of the processing device 1 while the first encapsulation module 5a is generating an encapsulation on a coated substrate. After one run or after a predetermined number n = 1, 2, 3,... of runs the second encapsulation module 5b is used for generating an encapsulation element on a number of subsequent coated substrates, while the first encapsulation module 5a undergoes a cleaning process. In this way a continuous operation of a coating device 1 for depositing an OLED coating and an encapsulation element on said OLED coating is provided.

## Description

### TECHNICAL FIELD

The present invention relates to a processing device for producing a layer system on a substrate, preferably a layer system including at least one layer of an organic light emitting semiconductor material (OLED), the device comprising: a configuration of one or more treatment stations for processing said substrate in said treatment stations, and a first encapsulation module comprising a first encapsulation tool for providing an encapsulation on said layer system deposited on said substrate. Furthermore, the invention relates to a method for processing a substrate, preferably for depositing a layer system including at least one layer of an organic light emitting semiconductor material (OLED) on a substrate.

### BACKGROUND OF THE INVENTION

In many technical fields multi-layer coatings deposited on a substrate are required. Particularly, in the field of electronics, the importance of displays and flat panels is increasing. For example, OLED (Organic Light Emitting Diode) panels are commercially produced by depositing a multi-layer system on a substrate. The multi-layer system includes at least one layer of an organic light emitting (OLED) semiconductor material. Usually, the resulting OLED device, e.g. an OLED display, a light source, an organic electronic device, a solar cell, a.s.o. comprises a substrate (e.g. of glass), an ITO (Indium Tin Oxide)-layer, at least one organic light emitting layer and a cathode.

Usually, OLED coating machines are configured as cluster tools having a central transfer chamber and various modules arranged around the transfer chamber for performing the different processing and/or coating steps.

Because the OLED layer system is an environmentally sensitive product and in order to prevent deterioration of the performance in ambient conditions it is required to apply an encapsulation or protective layer (system) on top of the OLED layer system. Encapsulation methods may include providing a glass or a metal cap or even a thin film encapsulation processes. In another embodiment the encapsulation layer may comprise a stack of organic and/or inorganic layers, an anti-scratch coating, etc.

For the provision of the encapsulation element the substrate is removed from the cluster-tool and transported into a facility called "glovebox" wherein the encapsulation process takes place.

However, the use of cluster systems involves some disadvantages. Particularly, although purity requirements and process conditions in the individual modules are satisfactory, cluster tools have quite a low throughput and poor performance. At least the performance is not sufficient for mass production of OLED devices. Furthermore, on the way between the coating system and the glovebox, the OLED may be damaged or polluted.

In order to improve the performance of OLED coating systems, in-line coating configurations have been used in order to be able to produce OLED devices continuously. In these systems substrates are transported through a number of subsequent treatment chambers to perform the necessary process steps sequently. The layers can be deposited on a single path through the system. The treatment chambers may comprise e.g. coating chambers, surface treatment chambers, etc.

An in-line coating system for the production of substrates coated with organic electroluminescent materials (OLED) is disclosed in EP 1 717 339 A2, the content of which is enclosed herewith by reference.

However, due to the fact that encapsulation chambers have to be cleaned frequently, e.g. at least every day, the encapsulation element is deposited on the coated substrate in an encapsulation station which is uncoupled and/or separated from the processing line. Otherwise, if the encapsulation module was integrated in the in-line coating system the transport of substrates through the line would have to be stopped during the cleaning process. Thus the production in the in-line coating system would have to be stopped completely during cleaning periods.

### OBJECT OF THE INVENTION

It is an object of the present invention to provide a coating and encapsulation device having a high throughput and ensuring a high and reliable purity level of an OLED product.

### TECHNICAL SOLUTION

This object is achieved by the provision of a processing device according to claim 1 and a method for producing a layer system on a substrate according to claim 12.

The inventive processing device for producing a layer system on a substrate, preferably a layer system including at least one layer of an organic light emitting semiconductor material (OLED) comprises: a configuration of one or more treatment stations for processing said substrate in said treatment stations, and a first encapsulation module comprising a first encapsulation tool for providing an encapsulation on said layer system deposited on said substrate. The processing device further comprises at least a second encapsulation module comprising at least a second encapsulation tool for providing an encapsulation on said layer system deposited on said substrate, and said processing device is configured to provide said encapsulation on said layer system deposited on said substrate either in said first encapsulation module or in said second encapsulation module alternatively.

By providing two encapsulation modules one of the modules, e.g. the second module, may be cleaned during a continuous operation of the processing device while the first encapsulation module generates an encapsulation element on a coated substrate. After one run or after a predetermined number n=1, 2, 3,... of runs the second encapsulation module is used for generating an encapsulation element on a number of subsequent coated substrates, while the first encapsulation module undergoes a cleaning process. In this way a continuous operation of a coating device for depositing an OLED coating and an encapsulation on said OLED coating is provided. While the complete production process is continuous, the treatment at the treatment and encapsulation stations may be static and/or stationary.

Thus the invention proposes a processing device which is a combined coating and encapsulation system having high performance and through-put by using the advantages of an in-line configuration of the treatment (coating) stations to deposit a multi-layer system on a substrate in a continuous operating/ production mode combined with the possibility to deposit at least one encapsulation (element) on the deposited multi-layer system. The encapsulation (element) may be a protective layer, a system of several protective layers, e.g. a stack of organic and/or inorganic layers as well as an anti-scratch-coating, a cover, etc. Due to the arrangement of two encapsulation chambers and the alternative use of the encapsulation chambers for depositing the encapsulation layer(s) on the OLED layer system the encapsulation chambers may be cleaned regularly without an interruption of the delivery of substrates through the combined in-line coating and encapsulation system. Particularly, the encapsulation modules/stations are operated and cleaned alternately.

In an in-line arrangement of the treatment stations, each substrate passes a linear deposition path. "Linear" means that the substrates pass through each treatment station on the way from a substrate load station to a substrate unload station. The substrates are not necessarily transported in the same direction all the time, but follow each other to be processed sequentially along said linear deposition path. The substrates to be processed pass the production line sequently, one after the other. The encapsulation modules may be coupled to the outlet of the coating line/deposition path, either directly or indirectly via e.g. a pump chamber, a buffer chamber or an intermediate chamber, in various arrangements.

The term "layer system" refers to a system having one or more layers. The layer(s) may be structured or unstructured, i.e. the layers may have a pattern or extend over the complete substrate area as a more or less homogenous thin layer. At least one layer may comprise an organic light emitting semiconductor material (OLED). Further layers may comprise organic and/or anorganic materials (e.g. metal layers).

Preferably, the configuration of the one or more treatment stations comprises at least one coating station for depositing a layer on said substrate.

The processing device may comprise a coating system with various treatment stations/modules. The treatment stations/modules comprise coating stations, but may also include etching stations, intermediate chambers, pump chambers, etc. The coating stations may perform different coating processes, e.g. PVD, CVD, PECVD, RF-PECVD, sputter processes, etc. The encapsulation system comprises at least two encapsulation modules which may be operated independently. Particularly the encapsulation modules may be operated optionally and selectively.

In a preferred embodiment the coating station comprises at least one tool for depositing an organic light emitting semiconductor layer (OLED) on said substrate. Because cathode materials and organic molecules used in organic light emitting displays (OLEDs) have a limited lifetime when exposed to oxygen or water, these systems require protection by applying an encapsulation (element) or protective layer (system). Encapsulation methods may include providing a glass or a metal cap or thin film encapsulation processes. Usually, the resulting OLED display comprises a substrate (e.g. of glass), an ITO (Indium Tin Oxide)-layer, at least one organic light emitting layer and a cathode. On top of this layer system enclosing the layer system, the encapsulation element is provided which may comprise a stack of organic and/or inorganic layers as well as an anti-scratch-coating.

Said first encapsulation module preferably comprises first means for cleaning at least one component of said first encapsulation module, and said second encapsulation module comprises second means for cleaning at least one component of said second encapsulation module. The cleaning may be done by means of a fast plasma etching process. It could, however, also be performed by exchanging (polluted) components of the encapsulation chambers and/or the encapsulation tools. It is also possible to clean components of the encapsulation station by providing access to the encapsulation chamber to be cleaned.

The treatment stations of said configuration of treatment stations may be arranged in-line. In this way a number of sequenced substrates can be coated in a continuous process of successive process steps.

In a preferred embodiment the first encapsulation module and the second encapsulation module are arranged parallel to each other. In this embodiment two or more encapsulation chambers may be coupled to the end of an in-line coating device, e.g. via a transfer chamber. The encapsulation chambers are arranged parallel to each other. This means that a (coated) substrate is either transported into a first encapsulation chamber in order to be processed or into a second (or third, fourth, a.s.o.) encapsulation chamber in order to be processed. The other chamber(s) is/are not entered by the substrate and may undergo a cleaning process, maintenance or exchange of components while providing the encapsulation element to cover the layer system in the first encapsulation module. Thus "parallel" does not have to be (but may be) understood in a strictly geometrical sense.

The substrates successively output from the coating line may be processed in the first and second or one of the various encapsulation chambers alternately. Therefore, one of the encapsulation chambers to be cleaned may be separated and/or uncoupled from the process while the other encapsulation chamber(s) provide(s) a continuous operation of the combined coating and encapsulation system. Furthermore, while an encapsulation process is performed in one of the chambers, an internal cleaning process, e.g. a plasma etching process, may be performed in the other chamber(s). In this case encapsulation and cleaning periods, respectively, can be alternated between the parallel encapsulation chambers after every encapsulation run, or after n encapsulation runs (n = 1, 2, 3,...) carried out in one of the encapsulation chambers. However, there may also be a change between the chambers after a predetermined period of time.

In a particular embodiment, the processing device comprises a transfer station arranged in-line with said configuration of one or more treatment stations, said transfer station being configured for receiving a substrate from said configuration of treatment stations and transferring a substrate to either of said first encapsulation module and said second encapsulation module. For example, the transfer chamber may be a rotation chamber comprising a rotatable transport system which may deliver a substrate into any of the encapsulation chambers and receive substrates from each of the encapsulation chambers. The transport system may also receive substrates output from the coating system and deliver substrates into a substrate unload station or into an intermediate module arranged between the rotation chamber and the substrate unload station.

The encapsulation modules may be arranged traverse, particularly perpendicular, to the transport direction of the substrates within the inline configuration of treatment stations. This includes an arrangement of encapsulation chambers arranged in a star-like cluster configuration about a transfer chamber.

In another embodiment, the first encapsulation module and the second encapsulation module are arranged in-line with the treatment stations of said configuration of treatment stations. In other words, the transport path of the substrates splits up in two (or a number corresponding to the number of encapsulation chambers) branches when the substrate has passed through the coating system. The substrate is delivered either in a first branch comprising the first encapsulation chamber or a second branch comprising the second encapsulation chamber (or a third branch, a.s.o.). After receiving an encapsulation the paths may be brought together again or continue separately into a substrate unload station.

In another embodiment of the invention the first encapsulation module and the second encapsulation module are arranged in-line with respect to each other.

In the in-line arrangement the encapsulation chambers are coupled to the last coating module down-stream the (in-line) arrangement of coating modules (with respect to the transport direction of the substrates) and in line with the coating modules. In other words, the first encapsulation chamber is coupled directly or indirectly with the last coating station, and the second encapsulation station is coupled in line with the first encapsulation station. A third encapsulation station may be coupled in line with the second encapsulation station, a.s.o. The encapsulation stations may have a first opening for receiving substrates and a second opening for releasing substrates. The first encapsulation chamber is coupled with the output opening of the coating line via its first opening. The second opening of the first encapsulation chamber is coupled with the first opening of the second encapsulation chamber. The second opening of the second encapsulation chamber is coupled with a substrate unload station directly or via one or more intermediate chambers.

In this embodiment every substrate passes through all encapsulation chambers arranged in-line. Usually, during the operation of the processing device, while a first layer system of a first substrate is encapsulated in one of the encapsulation chambers, the other (second) encapsulation chamber is cleaned by a cleaning plasma. Because a cleaning plasma usually has a higher etching rate than a coating plasma, the cleaning period in the second chamber is shorter than the coating period in the first chamber. In the next run another substrate is transferred in one of the first and second encapsulation chambers and encapsulated, while the other chamber is cleaned by a plasma. Usually, in this run the coated substrate is encapsulated in the second encapsulation chamber which had been cleaned in the preceding run. In other words, while the coatings of the substrates are alternately being encapsulated in the first and second encapsulation chamber, respectively, the respective other encapsulation chamber is cleaned.

Because the substrate passes all encapsulation chambers before or after they have been cleaned, it has to be ensured that these encapsulation chambers do not contain any residual gases. If necessary, an additional gas separation and/or pump chambers may be provided. In this way a substrate may pass (a) "dirty" or "clean" encapsulation chamber(s) before or after being encapsulated. The encapsulation always takes place in a sufficiently clean chamber.

Preferably, the processing device further comprises at least a third encapsulation module, wherein said first encapsulation module and said second encapsulation module are arranged parallel to each other and/or in-line with each other, and said third encapsulation module is arranged in-line with said first encapsulation module and/or said second encapsulation module, or said third encapsulation module is arranged parallel to said first encapsulation module and/or said second encapsulation module.

There may be more than two encapsulation chambers arranged in-line with and/or parallel to the first and second encapsulation chambers. In the case of more than two chambers, other operational modes may be used.

It is also possible to combine the first concept of parallel encapsulation chambers and the second concept of an arrangement of in-line encapsulation chambers. For example, there could be two pairs of encapsulation chambers arranged parallel, each pair consisting of two encapsulation chambers arranged in line. One of the parallel branches could be active, i.e. operated as described with respect to the in-line arrangement of encapsulation chambers, while the second branch could be cleaned by opening the chambers and/or cleaning the components by exchanging them.

According to the present invention a method for processing a substrate, preferably a method for depositing a layer system including at least one layer of an organic light emitting semiconductor material (OLED) on a substrate, comprises the steps of:
a) depositing a first layer system on a first substrate in at least one treatment station;
b) providing a first encapsulation on said first layer system of said first substrate in a first encapsulation module; and
c) cleaning a second encapsulation module arranged parallel or in-line with said first encapsulation module while performing step b).

A high scattering rate of particles within the encapsulation chamber causes coatings within the encapsulation chamber. These coatings may be deposited on another OLED device during a later encapsulation process unless the encapsulation chamber is cleaned regularly. Therefore, the present invention involves a cleaning step c) for cleaning a second encapsulation chamber without interrupting the continuous coating and encapsulation process.

The encapsulation chamber may be cleaned either by exchanging the polluted i.e. coated, components of the encapsulation tool, e.g. a few times every day. Alternatively, internal processes can be used to clean the encapsulation chamber, e.g. by providing a cleaning plasma in the encapsulation chamber.

The method may further comprise the steps of:
d) depositing a second layer system on a second substrate in said at least one treatment station;
e) providing a second encapsulation on said second layer system of said second substrate in a second encapsulation module; and
f) cleaning said first encapsulation station while performing step e).

Particularly, the first substrate and the second substrate are processed in said at least one treatment station of the arrangement of treatment stations one after the other. The treatment stations may be arranged in line as described above.

Preferably, the first layer system of said first substrate is encapsulated in said first encapsulation module during a first period of time, and the second layer system of said second substrate is encapsulated in said second encapsulation module during a second period of time, said second period of time being temporarily displaced from said first period of time. The period of cleaning in one encapsulation chamber and the period of encapsulating in the other encapsulation chamber usually overlap. Two encapsulation processes in two different chambers may partly overlap.

Particularly, the first layer system deposited on said first substrate is encapsulated in said first encapsulation module in a run n, and said second layer system deposited on said second substrate is encapsulated in said second encapsulation module in a subsequent run n + m following run n, with n, m = 1, 2, 3,... There are (m-1) runs between run n of a first substrate and run n+m of a second substrate.

Said cleaning steps c) and f) may be carried out by using a plasma cleaning process, particularly a fast plasma etching process. Alternatively, polluted components may be "cleaned" by exchanging them or cleaning them mechanically.

Preferably the treatment in said method steps a) and d) include depositing at least one organic and/or one inorganic layer on said substrates.

The features described above are meant to be protected by themselves or in any combination with the described method and/or device features.

### BRIEF DESCRIPTION OF THE DRAWINGS

Further objects and advantages result from the following description of specific embodiments.

### The figures show

Fig. 1 a schematic plan view of a processing device in accordance with a first embodiment of the invention; and
Fig. 2 a schematic plan view of a processing device in accordance with a second embodiment of the invention.

### DESCRIPTION OF SPECIFIC EMBODIMENTS

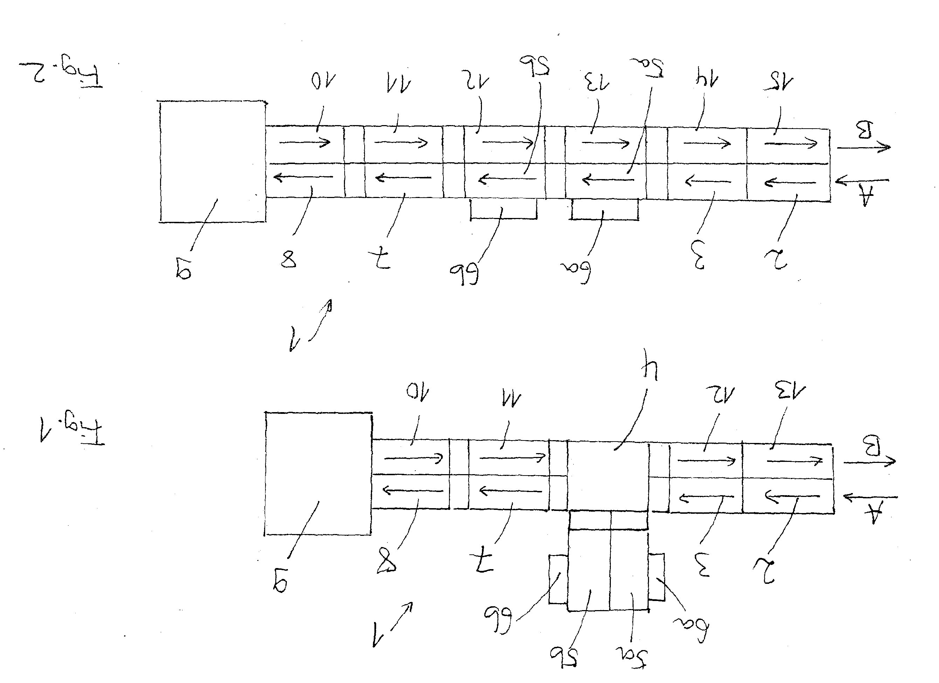

Figure 1 shows a schematic plan view of a part of a processing device 1 for producing a multi-layer system on a substrate, particularly an organic light emitting diode (OLED) display.

The processing device 1 includes an in-line arrangement of a number of treatment stations indicated by the arrow A. The arrangement of treatment stations particularly comprises coating stations for depositing organic and/or anorganic structured or unstructured layers on a substrate, but may also comprise e.g. plasma etching stations, intermediate chambers, etc. The coating stations may include any kind of treatment tools, e.g. sputter tools, CVD evaporation tools, etc. The substrates are sequentially transported through the various treatment chambers.

In the embodiment shown in Figure 1 one of the last treatment stations may be a metal coating station 2. The metal coating station 2 is provided for forming the upper-most layer of the layer system. After the deposition of the metal layer in the metal coating chamber 2, the substrate (now comprising the complete layer system except for the encapsulation) is transported into a transfer chamber 4 via an intermediate chamber 3.

The transfer chamber 4 comprises a transfer means, e.g. a rotatable transport system including a rotatable receiver to receive the substrate carrier with the coated substrate. The transport system can be rotated to be aligned with either a first encapsulation chamber 5a or a second encapsulation chamber 5b in order to deliver the substrate into either the first or the second encapsulation chamber 5a or 5b.

In this embodiment the first encapsulation chamber 5a is arranged parallel to the second encapsulation chamber 5b so that a substrate can be transported into the first encapsulation chamber 5a or into the second encapsulation chamber 5a alternatively. Both encapsulation chambers 5a and 5b include encapsulation tools 6a and 6b. The encapsulation tools 6a and 6b are provided for depositing encapsulation material on the layer system which had been deposited on the substrate in the coating system upstream of the transfer chamber 4.

The encapsulation chambers 5a and 5b are arranged perpendicularly to the regular transport direction of the substrates. The regular transport direction of the substrate is indicated by a number of arrows having the direction of arrow A.

Both the first and the second encapsulation chambers 5a and 5b are arranged on one side of the transfer chamber 4, but of course they may also be arranged the other side of the transfer chamber 4 and/or the transfer chambers 5a and 5b may be arranged on different sides of the transfer chamber 4. There may also be further encapsulation chambers besides the first encapsulation chamber 5a and the second encapsulation chamber 5b arranged on any side of the transfer chamber 4.

During the process of providing an encapsulation layer on the OLED multilayer system in either the first encapsulation chamber 5a or the second encapsulation chamber 5b, the other one of the encapsulation chambers is cleaned by an adequate cleaning process, e.g. by a (plasma) etching process, or by an exchange of polluted components of the encapsulation chamber 5a, 5b and/or encapsulation tools 6a, 6b.

After the deposition of the encapsulation layer on the OLED layer system, the substrate is removed from the first and second encapsulation chamber 5a and 5b, respectively, and transported back into the transfer chamber 4. Afterwards, the substrate is transported into a substrate unload station 9 via intermediate chambers 7 and 8. The intermediate chambers may be buffer chambers, post-treatment chambers, process chambers, coating chambers, etc. In the substrate unload station 9 the substrate is removed from the carrier.

After the substrate has been removed from the carrier the empty carrier is transported back into a load station to receive another substrate through the cambers 10, 11, 4, 12, 13 and on a path indicated by the arrow B.

The processing device 1 is operated continuously. The substrate is transported from one chamber to the next to carry out various treatment steps. Several substrates are treated within the processing device sequentially.

While one of first and a second encapsulation chambers 5a and 5b is operable to provide an encapsulation layer on a number of coated substrates delivered sequentially into the respective encapsulation chamber 5a or 5b, the other one of the first and second encapsulation chambers 5a and 5b, respectively, may be uncoupled from the process and subject to a cleaning or maintenance process. Thus, a continuous in-line operation of the processing device 1 including an encapsulation process is ensured even if one of the encapsulation chambers 5a or 5b is not in use. When providing more than two encapsulation chambers at least one of the chambers has to be operable, while the other encapsulation chambers may be uncoupled from the process.

The first and the second encapsulation chambers 5a and 5b may be operable alternatively, optionally and/or selectively, i.e. coated substrates delivered sequentially into the transfer chamber 4 may be delivered into the first encapsulation chamber 5a and the second encapsulation chamber 5b alternately. The encapsulation chamber selected to perform the encapsulation process to a particular substrate may be alternated after every run, after a certain number of n consecutive runs or after a certain operating time, e.g. every day. However, many other operating modes are possible. The operation mode substantially depends on the requirements of the encapsulation process.

Figure 2 illustrates another embodiment of the invention. Like the arrangement shown in Figure 1 the processing device 1 includes an in-line arrangement of coating chambers represented by the arrow A. The last layer of the multi-layer system deposited on a substrate in the treatment arrangement A is provided in a metal coating chamber 2.

After the deposition of the metal layer, the coated substrate is transported either into the first encapsulation chamber 5a via an intermediate or treatment chamber 3 or into the second encapsulation chamber 5b via the intermediate or treatment chamber 3 and the first encapsulation chamber 5a. Both encapsulation chambers 5a and 5b include encapsulation tools 6a and 6b.

In this embodiment, the first encapsulation chamber 5a and the second encapsulation chamber 5a are arranged in-line in the regular transport direction represented by a number of arrows having the direction of arrow A. This means that each coated substrate is transported through both encapsulation chambers 5a and 5b. However, each coated substrate receives an encapsulation either in the first encapsulation chamber 5a or the second encapsulation chamber 5b. Of course, more than two encapsulation chambers may be arranged in-line, and a particular substrate receives an encapsulation by treatment in only one of these chambers.

During the encapsulation process in the first or second encapsulation chamber 5a and 5b the other one of the encapsulation chambers 5a and 5b, respectively, undergoes a cleaning process.

In this embodiment the cleaning process is carried out by providing a plasma, e.g. by a plasma etching process. In order to achieve the best operating conditions, the cleaning period is selected to be shorter than the encapsulation period and/or the cleaning process may be carried out after every encapsulation process. Usually, the cleaning period is not longer than the coating period because the plasma etching rates for a cleaning process (cleaning plasma) are usually higher than the rates of coating plasma. Thus the cycle time for the cleaning process is usually shorter than the cycle time for the encapsulation process.

As the substrate passes through both encapsulation chambers 5a and 5b, no matter whether the encapsulation is provided in the first or the second encapsulation chamber 5a, 5b, it should be ensured that when the substrate receives the encapsulation in the first encapsulation chamber 5a, there are no residual gases in the second encapsulation chamber 5b when the substrate passes through the second encapsulation chamber 5b after the encapsulation process. On the other hand, when the coated substrate undergoes an encapsulation process in the second encapsulation chamber 5b it should be ensured that there are no residual gases within the first encapsulation chamber 5a when the coated substrate passes the first encapsulation chamber 5a on its way to the second encapsulation chamber 5b to receive the encapsulation layer. For this purpose, gas separation or additional pump chambers may be provided.

After the encapsulation process, the coated and encapsulated substrate is transported into a substrate unload chamber 9 via intermediate chambers, process chambers, coating chambers, and/or treatment chambers 7 and 8. The empty carrier is transported back to a load station (not shown) via a transport path 10, 11, 12, 13, 14, 15 and further via a path indicated by arrow B. The chambers along the paths may be transfer chambers, intermediate chambers and/or treatment chambers.

## Claims

1. A processing device (1) for producing a layer system on a substrate, preferably a layer system including at least one layer of an organic light emitting semiconductor material (OLED), the device comprising:
a configuration of one or more treatment stations (A, 2) for processing said substrate in said treatment stations (A, 2), and
a first encapsulation module (5a) comprising a first encapsulation tool (6a) for providing an encapsulation on said layer system deposited on said substrate,
**characterized in that**
the processing device (1) further comprises at least a second encapsulation module (5b) comprising at least a second encapsulation tool (6b) for providing an encapsulation on said layer system deposited on said substrate, and
said processing device (1) is configured to provide said encapsulation on said layer system deposited on said substrate either in said first encapsulation module (5a) or in said second encapsulation module (5b) alternatively.

2. The processing device (1) according to claim 1, wherein said configuration of said one or more treatment stations (A, 2) comprises at least one coating station for depositing a layer on said substrate.

3. The processing device (1) according to claim 2, wherein said at least one coating station comprises at least one tool for depositing an organic light emitting semiconductor layer (OLED) on said substrate.

4. The processing device (1) according to any of the previous claims, wherein said first encapsulation module (5a) comprises first means for cleaning at least one component of said first encapsulation module (5a), and said second encapsulation module (5b) comprises second means for cleaning at least one component of said second encapsulation module (5b).

5. The processing device (1) according to any of the previous claims, wherein said treatment stations (A, 2) of said configuration of treatment stations are arranged in-line.

6. The processing device (1) according to any of the previous claims, wherein said first encapsulation module (5a) and said second encapsulation module (5b) are arranged parallel to each other.

7. The processing device (1) according to claim 6, wherein said processing device (1) comprises a transfer station (4) arranged in-line with said configuration of one or more treatment stations (A, 2), said transfer station (4) being configured for receiving a substrate from said configuration of treatment stations (A, 2) and for transferring a substrate to either of said first encapsulation module (5a) and said second encapsulation module (5b).

8. The processing device (1) according to any of the previous claims, wherein said encapsulation modules (5a, 5b) are arranged traverse, particularly perpendicular, to the transport direction (A) of the substrates.

9. The processing device (1) according to any of the previous claims, wherein said first encapsulation module (5a) and said second encapsulation module (5b) are arranged in-line with said treatment stations (A, 2) of said configuration of treatment stations.

10. The processing device (1) according to any of the previous claims, wherein said first encapsulation module (5a) and said second encapsulation module (5b) are arranged in-line with each other.

11. The processing device (1) according to any of the previous claims, wherein said processing device (1) further comprises at least a third encapsulation module, wherein said first encapsulation module (5a) and said second encapsulation module (5b) are arranged parallel to each other and/or in-line with each other, and said third encapsulation module is arranged in-line with said first encapsulation module (5a) and/or said second encapsulation module (5b), or said third encapsulation module is arranged parallel to said first encapsulation module (5a) and/or said second encapsulation module (5b).

12. A method for processing a substrate, preferably a method for depositing a layer system including at least one layer of an organic light emitting semiconductor material (OLED) on a substrate, said method comprising the steps of:
a) depositing a first layer system on a first substrate in at least one treatment station (A, 2);
b) providing a first encapsulation on said first layer system of said first substrate in a first encapsulation module (5a); and
c) cleaning a second encapsulation module (5b) arranged parallel or in-line with said first encapsulation module (5a) while performing step b).

13. The method according to claim 12, further comprising the steps of:
d) depositing a second layer system on a second substrate in said at least one treatment station (A, 2);
e) providing a second encapsulation on said second layer system of said second substrate in a second encapsulation module (5b); and
f) cleaning said first encapsulation station (5a) while performing step e).

14. The method according to claim 13, wherein said first substrate and said second substrate are processed in said at least one treatment station (A, 2) one after the other.

15. The method according to claim 14, wherein said first layer system of said first substrate is encapsulated in said first encapsulation module (5a) during a first period of time, and said second layer system of said second substrate is encapsulated in said second encapsulation module (5b) during a second period of time, said second period of time being temporarily displaced from said first period of time.

16. The method according to any of the previous claims 12 to 15, wherein said first layer system deposited on said first substrate is encapsulated in said first encapsulation module (5a) in a run n, and said second layer system deposited on said second substrate is encapsulated in said second encapsulation module (5b) in a subsequent run n + m following run n, with n, m = 1, 2, 3,...

17. The method according to any of the previous claims 12 to 16, wherein said cleaning steps c) and f) are carried out by using a plasma cleaning process.

18. The method according to any of the previous claims 12 to 17, wherein said treatment in said method steps a) and d) include depositing at least one organic and/or one inorganic layer on said substrates.

## Amended claims

### Amended claims in accordance with Rule 137(2) EPC.

**1.** A processing device (1) for producing a layer system on a substrate, preferably a layer system including at least one layer of an organic light emitting semiconductor material (OLED), the device comprising:
a configuration of one or more treatment stations (A, 2) for processing said substrate in said treatment stations (A, 2), and
a first encapsulation module (5a) comprising a first encapsulation tool (6a) for providing an encapsulation on said layer system deposited on said substrate,
at least a second encapsulation module (5b) comprising at least a second encapsulation tool (6b) for providing an encapsulation on said layer system deposited on said substrate,
**characterized in that**
said first encapsulation module (5a) comprises first means for plasma cleaning of at least one component of said first encapsulation module (5a), and said second encapsulation module (5b) comprises second means for plasma cleaning of at least one component of said second encapsulation module (5b); and
said processing device (1) is configured to provide said encapsulation on said layer system deposited on said substrate either in said first encapsulation module (5a) or in said second encapsulation module (5b) alternatively.

**2.** The processing device (1) according to claim 1, wherein said configuration of said one or more treatment stations (A, 2) comprises at least one coating station for depositing a layer on said substrate.

**3.** The processing device (1) according to claim 2, wherein said at least one coating station comprises at least one tool for depositing an organic light emitting semiconductor layer (OLED) on said substrate.

**4.** The processing device (1) according to any of the previous claims, wherein said treatment stations (A, 2) of said configuration of treatment stations are arranged in-line.

**5.** The processing device (1) according to any of the previous claims, wherein said first encapsulation module (5a) and said second encapsulation module (5b) are arranged parallel to each other.

**6.** The processing device (1) according to claim 5, wherein said processing device (1) comprises a transfer station (4) arranged in-line with said configuration of one or more treatment stations (A, 2), said transfer station (4) being configured for receiving a substrate from said configuration of treatment stations (A, 2) and for transferring a substrate to either of said first encapsulation module (5a) and said second encapsulation module (5b).

**7.** The processing device (1) according to any of the previous claims, wherein said encapsulation modules (5a, 5b) are arranged traverse, particularly perpendicular, to the transport direction (A) of the substrates.

**8.** The processing device (1) according to any of the previous claims, wherein said first encapsulation module (5a) and said second encapsulation module (5b) are arranged in-line with said treatment stations (A, 2) of said configuration of treatment stations.

**9.** The processing device (1) according to any of the previous claims, wherein said first encapsulation module (5a) and said second encapsulation module (5b) are arranged in-line with each other.

**10.** The processing device (1) according to any of the previous claims, wherein said processing device (1) further comprises at least a third encapsulation module, wherein said first encapsulation module (5a) and said second encapsulation module (5b) are arranged parallel to each other and/or in-line with each other, and said third encapsulation module is arranged in-line with said first encapsulation module (5a) and/or said second encapsulation module (5b), or said third encapsulation module is arranged parallel to said first encapsulation module (5a) and/or said second encapsulation module (5b).

**11.** A method for processing a substrate, preferably a method for depositing a layer system including at least one layer of an organic light emitting semiconductor material (OLED) on a substrate, said method comprising the steps of:
a. depositing a first layer system on a first substrate in at least one treatment station (A, 2);
b) providing a first encapsulation on said first layer system of said first substrate in a first encapsulation module (5a); and
c) cleaning a second encapsulation module (5b) arranged parallel or in-line with said first encapsulation module (5a) while performing step b) by using a plasma cleaning process.

**12.** The method according to claim 12, further comprising the steps of:
d) depositing a second layer system on a second substrate in said at least one treatment station (A, 2);
e) providing a second encapsulation on said second layer system of said second substrate in a second encapsulation module (5b); and
f) cleaning said first encapsulation station (5a) while performing step e) by using a plasma cleaning process.

**13.** The method according to claim 12, wherein said first substrate and said second substrate are processed in said at least one treatment station (A, 2) one after the other.

**14.** The method according to claim 13, wherein said first layer system of said first substrate is encapsulated in said first encapsulation module (5a) during a first period of time, and said second layer system of said second substrate is encapsulated in said second encapsulation module (5b) during a second period of time, said second period of time being temporarily displaced from said first period of time.

**15.** The method according to any of the previous claims 11 to 14, wherein said first layer system deposited on said first substrate is encapsulated in said first encapsulation module (5a) in a run n, and said second layer system deposited on said second substrate is encapsulated in said second encapsulation module (5b) in a subsequent run n + m following run n, with n, m = 1, 2, 3,...

**16.** The method according to any of the previous claims 11 to 15, wherein said treatment in said method steps a) and d) include depositing at least one organic and/or one inorganic layer on said substrates.
